(19) Europäisches Patentamt
European Patent Office
Office européen des brevets

(11) **EP 4 542 302 A1**

(12) **EUROPEAN PATENT APPLICATION**

(43) Date of publication:
**23.04.2025  Bulletin 2025/17**

(21) Application number: **24198801.3**

(22) Date of filing: **06.09.2024**

(51) International Patent Classification (IPC):
**G03F 7/00** (2006.01)

(52) Cooperative Patent Classification (CPC):
**G03F 7/70083; G03F 7/70283; G03F 7/70358; G03F 7/70433**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.10.2023  DE 102023127297**

(71) Applicant: **Carl Zeiss SMT GmbH**
**73447 Oberkochen (DE)**

(72) Inventor: **Feldmann, Heiko**
**73447 Oberkochen (DE)**

(74) Representative: **Frank, Hartmut**
**Bonsmann Bonsmann Frank**
**Patentanwälte**
**Reichspräsidentenstraße 21-25**
**45470 Mülheim a. d. Ruhr (DE)**

(54) **METHOD FOR OPERATING A MICROLITHOGRAPHIC PROJECTION EXPOSURE APPARATUS, MICROLITHOGRAPHIC MASK AND PROJECTION EXPOSURE APPARATUS**

(57)     The invention relates to a method for operating a microlithographic projection exposure apparatus (1), in which for the - at least partial - compensation of an image offset produced due to the extent for example of dipole illumination (300) and which ultimately results in an unwanted loss of imaging contrast (M3D effect), the following are provided: field-dependent illumination, in which different field regions of the object plane (6) are illuminated with differing illumination settings, and the production of a field-dependent image offset during the imaging of the object plane onto the image plane (12). Here, the interaction between the field-dependent illumination and the field-dependent image offset can lead to the loss of imaging contrast as a whole being reduced. The field-dependent illumination can be implemented for example by a MEMS facet mirror (20) in the illumination device (2), and the field-dependent image offset can be implemented for example by a horizontal and/or vertical mask distortion in combination with an adapted feed modification.

*Vertical structures / horizontal dipole*

**Fig. 6**

EP 4 542 302 A1

**Description**

This application claims priority of German Patent Application DE 10 2023 127 297.7 filed on October 6, 2023. The content of this application is hereby incorporated by reference.

BACKGROUND OF THE INVENTION

Field of the invention

The invention relates to a method for operating a microlithographic projection exposure apparatus, to a microlithographic mask and to a microlithographic projection exposure apparatus.

Prior art

Microlithography is used to produce microstructured, electronic components. The microlithography process is performed in what is known as a projection exposure apparatus, which has an illumination device and a projection lens. The image of a mask (= reticle) illuminated with the illumination device is projected here by means of the projection lens onto a substrate (for example a silicon wafer), which has been coated with a light-sensitive layer (photoresist) and is arranged in the image plane of the projection lens, in order to transfer the mask structure to the light-sensitive coating of the substrate.

In projection lenses designed for the EUV range, e.g. at wavelengths of e.g. approximately 13 nm, approximately 11 nm, approximately 7 nm or approximately 4 nm, mirrors are used as optical components for the imaging process owing to the lack of availability of suitable light-transmissive refractive materials.

One problem that occurs in practice is that three-dimensional mask effects (also known as mask 3D effects or "M3D" for short) lead to a wavefront tilt and an image offset, which is dependent on the illumination angle or the irradiation direction of the illumination on the mask. In extensive illumination (for example dipole illumination), this results in an image blur and consequently a decrease in contrast in the image generated in the wafer plane, which can cause severe problems regarding the performance and quality of the lithography process.

Known approaches for overcoming this problem comprise in particular the use of new mask materials, new illumination modes and also what is known as split dipole illumination, in which the exposure or scanning operation is divided into two exposure operations with differing illumination poles. However, the aforementioned known approach of split dipole illumination entails an unwanted decrease in the throughput that is achieved in the lithography process and/or the generation of additional image errors (in particular overlay errors), and even with the remaining measures mentioned this problem can be solved only to an unsatisfactory extent.

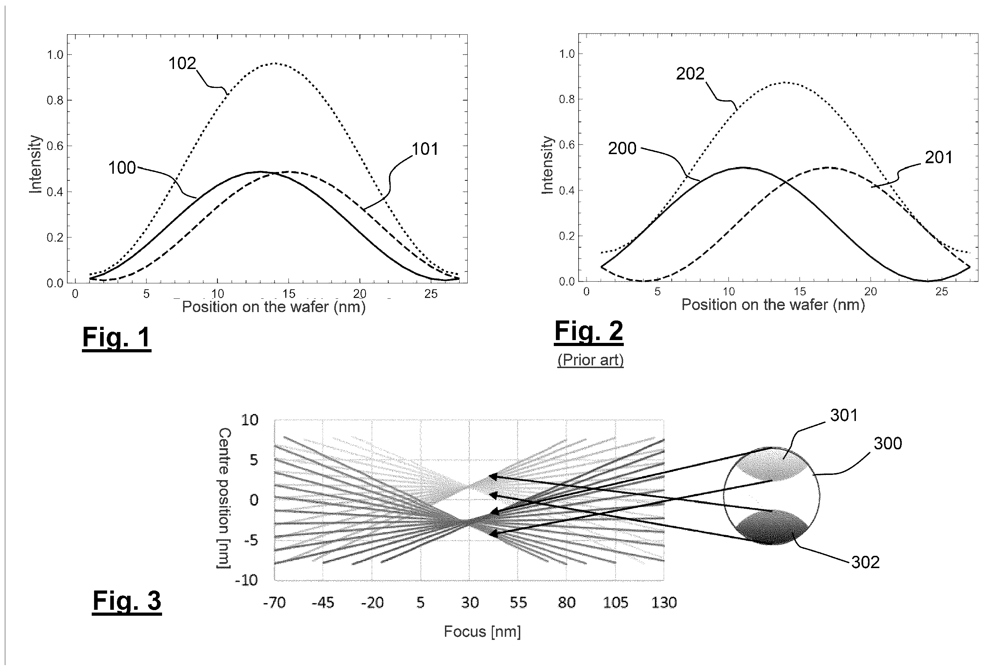

The problem relating to offset in the case of dipole illumination in the prior art will be explained in more detail below with reference to Figure 3:
Figure 3 (corresponding to Figure 4 in WO 2020/221556 A1) schematically illustrates an illumination pupil of an EUV projection exposure apparatus with dipole illumination, the two poles of which are shown in light and dark only for the purposes of distinctness. Due to the distance between the poles and the distance from the optical axis, an image offset of (in the present example) approximately -3 nm for one pole and approximately +3 nm for the other pole, that is to say overall an offset of approximately 6 nm, occurs, as can be seen.

Figure 2 illustrates (likewise schematically) the overlay image resulting therefrom in the image representation on the wafer plane. Incoherent superposition of the two single pole images (according to the continuous and dashed curves, respectively) results in the dotted cumulative curve.

This cumulative curve shows that the intensity at the periphery does not return completely to zero but merely to a value of approximately 0.15, and the maximum is not 1.0 either but somewhat less than 0.9, and as a result the contrast ratio of 100% is reduced to approximately 75%, which, as already mentioned, can result in severe performance and quality disadvantages.

By contrast, Figure 1 shows a situation with M3D effects which are reduced according to the invention, as a result of which the contrast ratio - as can be seen - can be improved significantly to, in the example, 90%; this is described in detail further below.

Regarding the prior art, reference is made merely by way of example to the already mentioned WO 2020/221556 A1 and to DE 10 2014 217 611 A1.

SUMMARY OF THE INVENTION

It is an object of the present invention to provide a method for operating a microlithographic projection exposure apparatus, a microlithographic mask and a microlithographic projection exposure apparatus, with which improved compensation for aberrations caused by mask structures to be imaged is made possible.

This object is achieved according to the features of the independent claims.

Advantageous refinements of the invention are described in the dependent claims.

A method according to the invention serves for operating a microlithographic projection exposure apparatus having an illumination device and a projection lens, wherein the illumination device illuminates a mask located in an object plane of the projection lens, and the projection lens images structures on this mask onto a light-sensitive layer located in an image plane of the projection lens, wherein in a scanning operation the respective illuminated region of the mask is varied.

The illumination device can have in particular a spatially extended radiation field with two or more illumination poles which are spaced apart horizontally, i.e. in an x-direction, and/or vertically, i.e. in a y-direction, which, as described above, results in an image offset on the light-sensitive layer and consequently in an unwanted loss of imaging contrast due to the M3D effect.

The method according to the invention is characterized in that

- the illumination of the mask takes place as field-dependent illumination, in which different field regions of the object plane are illuminated with differing illumination settings, and

- during imaging of the object plane onto the image plane, a field-dependent image offset is produced, in which differing field regions of the object plane are converted to differing image offsets.

Here, an illumination setting is understood to mean the intensity distribution in a pupil plane of the illumination device.

According to an embodiment, the interaction between the field-dependent illumination and the field-dependent image offset leads to an imaging contrast which results during the imaging onto the image plane being increased compared to imaging without a field-dependent image offset.

In other words, owing to the field-dependent illumination, the illumination distribution is modified in a field-dependent manner such that this modification can be effected, when the field-dependent image offset is produced, in a manner such that the interfering offset is compensated for, as a result of which the ultimately resulting image offset as a whole can be reduced and consequently the imaging contrast can be increased.

According to an embodiment, the mask is illuminated via an elongate scanning slit, in particular in the shape of a circle segment, wherein the scanning direction runs transversely to the scanning slit and wherein a plurality of field regions of the object plane are illuminated during the scanning operation in each case with differing illumination settings. Here, in particular at least two field regions of the object plane can overlap one another.

According to an embodiment, the field-dependent image offset is produced during the imaging onto the image plane in dependence on the transverse directional position of the radiation that is incident on the scanning slit.

In other words, the degree of freedom transversely to the scanning slit, i.e. a variation in the y-direction (the direction of the scan), is utilized to separately image the individual poles with the field-dependent illumination more or less in this transverse direction in order to thus produce a desired compensating offset via the field-dependent image offset.

According to an embodiment, the field-dependent illumination of the mask takes place via a facet mirror arrangement or a mirror array arrangement having micro-electromechanical systems (MEMS), wherein the radiation from a first illumination pole leads to lighting mainly in a lower region of the scanning slit and the radiation from a second illumination pole leads to lighting mainly in an upper region of the scanning slit.

Offset compensation according to the invention can be carried out particularly effectively if, in a refinement, a separating dark field is provided between the lighting in the upper region of the scanning slit and the lighting in the lower region of the scanning slit.

The field-dependent image offset can in embodiments of the invention be produced via a distortion profile integrated into the mask structures.

In particular, the horizontal mask structures and/or the vertical mask structures can for this purpose each have a specified distortion profile. Furthermore, in this connection, the mask feed and/or the feed of the light-sensitive layer is modified correspondingly during the scanning operation for compensating for the distortion profile compared to a nominal mask feed.

Here, differences arise depending on whether during the illumination of the mask in each case spaced-apart illumination poles are arranged vertically or horizontally in the scanning slit main direction:

- for reducing the image offset in the case of *horizontally* spaced-apart illumination poles (for imaging preferably vertically oriented structures), the mask structures should preferably be distorted in the horizontal direction, wherein this horizontal distortion can be compensated for by an additional movement offset of the mask and/or of the light-sensitive layer in the horizontal direction;

- for reducing the image offset in the case of *vertically* spaced-apart illumination poles (for imaging mainly horizontally oriented structures), the mask structures should preferably be distorted in the vertical direction, wherein this vertical distortion can be compensated for by a feed speed between the mask and the light-sensitive layer which deviates from a nominal feed speed.

A *diagonal* arrangement or orientation of the illumination poles with respect to the scanning slit main direction is likewise conceivable and would imply a combination of the two aforementioned measures.

The proposed mask distortion tends to lead to a deterioration of the imaging quality for the dipole single images. However, this effect fades into the background considering the achievable offset compensation according to the invention, in other words there is an optimum compromise which will be explained in further detail below.

Even if the invention as part of this disclosure is described primarily using dipole illumination apparatuses, the application of the present invention should not be limited to dipole illumination apparatuses, but can also be used - possibly with appropriate modifications - for offset compensation in other illumination sources which are not approximately in the form of individual points (e.g. approximately line-type illumination sources or complex illumination pupils optimized by SMO (= "source-mask optimization") and possibly also in the case of n-pole illumination with n > 2, for example quadrupole illumination.

Regarding possible illumination settings, reference is made by way of example to the publication by L. Wischmeier et al.: "High-NA EUV lithography optics becomes reality," Proc. SPIE 11323, Extreme Ultraviolet (EUV) Lithography XI, 1132308 (23 March 2020); doi: 10.1117/12.2543308, see Figures 3b and 3c thereof.

In a preferred embodiment of the invention, the aforementioned distortions in a ring-segment-shaped scanning slit, which extends in the horizontal direction and in which the field-dependent illumination distribution varies in the transverse direction, can be implemented in a first approximation according to one or more of the following transformation formulas:

- distortion of the vertical mask structures according to

$$(x,y) \rightarrow (x + dfx^*(y - rfs(x)),y),$$

and/or
- distortion of the horizontal mask structures according to

$$(x,y) \rightarrow (x,y + dfy^*(y - rfs(x))),$$

where:

rfs(x)   describes a profile of the y-component of a specified distortion zero line of the scanning slit, depending on the x-position, and

dfx,dfy   represents a specified vertical or horizontal distortion factor, wherein both factors may also be identical.

In further embodiments, the field-dependent image offset can be implemented (alternatively or possibly additionally) by a manipulation carried out during the scanning operation within the projection lens.

Furthermore, a microlithographic mask is proposed as part of the invention, which mask is designed for use in a previously described method, i.e. which is designed in particular using targeted distortions for producing a field-dependent image offset or at least as an essential component hereof (after all, the entire field-dependent image offset generally additionally comprises compensatory adaptations in the mask/wafer feed).

Furthermore, a projection exposure apparatus is proposed as part of the invention, which projection exposure apparatus is designed for carrying out a previously described method.

Further refinements of the invention are apparent from the description and the dependent claims.

The invention is explained in greater detail below on the basis of exemplary embodiments shown in the accompanying figures.

BRIEF DESCRIPTION OF THE DRAWINGS

In the figures:

| | |
|---|---|
| Figures 1 and 2 | show spatially dependent intensity diagrams for elucidating the imaging quality on a wafer exposed to dipole illumination, wherein Figure 1 shows the intensity profile with an offset compensation according to the invention and Figure 2 shows, for comparison purposes, the profile without this offset compensation; |
| Figure 3 | shows a schematic illustration elucidating the formation of the imaging offset in the case of symmetric dipole illumination; |
| Figure 4 | shows a schematic illustration of the division of the dipole illumination into an upper and a lower field with a horizontal dipole orientation; |
| Figure 5 | shows a schematic illustration of a horizontal mask distortion for distortion compensation with horizontal dipole orientation; |
| Figure 6 | shows a schematic diagram of the intensity distribution in the scanning direction which results from the horizontal mask distortion; |
| Figures 7a,b | show schematic illustrations for elucidating the effect of a horizontal mask distortion written into the mask structure; |
| Figure 8 | shows a schematic illustration of the division of the dipole illumination into an upper and a lower field with vertical dipole orientation (for imaging primarily horizontal structures); |
| Figure 9 | shows a schematic illustration of a horizontal mask distortion for distortion compensation with vertical |

dipole orientation;

Figure 10     shows a schematic diagram of the intensity distribution in the scanning direction resulting from the vertical mask distortion;

Figures 11a,b     show schematic illustrations for elucidating a vertical mask distortion written into the mask structure;

Figure 12     shows a diagram illustrating the attainable contrast ratio as a function of the distortion factor;

Figure 13     shows a schematic illustration of a MEMS facet mirror arrangement for implementing field-dependent illumination;

Figure 14     shows a schematic illustration of an embodiment with a narrower field division with a separating dark field located therebetween;

Figure 15     shows an intensity distribution resulting from the intensity distribution of Figure 14;

Figures 16 and 17     show schematic illustrations of the intensity distribution in the scanning direction with a narrower field division and a distortion factor 4 nm/mm (Figure 17) compared with the intensity distribution without offset (Figure 16); and

Figure 18     shows a schematic illustration of a projection exposure apparatus designed for operation in the EUV range.

## DETAILED DESCRIPTION OF PREFERRED EMBODIMENTS

The embodiments described below have in common that during the operation of a microlithographic projection exposure apparatus, field-dependent illumination during the scanning operation is combined with an image offset produced in a targeted manner for compensating for three-dimensional mask effects and an associated unwanted decrease in contrast, wherein this image offset is realized in different ways depending on the embodiment.

Figures 1-3 show schematic diagrams for elucidating the concept according to the invention, which were already explained in more detail in the introductory part.

The imaging offset, shown in Figure 3, between the two dipole illumination sources 301, 302 of a dipole - denoted by 300 as a whole - of, in the example, approximately 6 nm leads, according to Figure 2, in the incoherent superposed imaging between a left pole 200 and a right pole 201 on the wafer, in sum 202 to a contrast ratio which is reduced to approximately 75% with corresponding disadvantages for the performance and quality of the entire lithographic process. With the offset compensation according to the invention, it is possible according to Figure 1 to achieve an improved contrast ratio of, in the example, approximately 93% (see the cumulative intensity 102 in Figure 1) by reducing the offset between a left pole 100 and a right pole 101.

However, the offset compensation measures described in more detail further below tend to be detrimental to the contrast ratio of the imaging of the individual poles, which can be seen from a comparison between the curves 100, 101 and 200, 201; the individual curves 100, 101 are somewhat flatter than the curves 200, 201, i.e. the individual contrast ratio is reduced to approximately 95% compared to Figure 2, which, in the example, nevertheless means a significant contrast improvement for the cumulative intensity 102 due to the reduced offset.

## Implementation of the field-dependent illumination

To implement the desired offset compensation, it is first necessary to produce a field-dependent illumination distribution in which different field regions of the object plane are illuminated with differing illumination settings, as a result of which the radiation from the individual illumination poles is converted in a field-dependent or pole-dependent manner into different illumination distribution patterns.

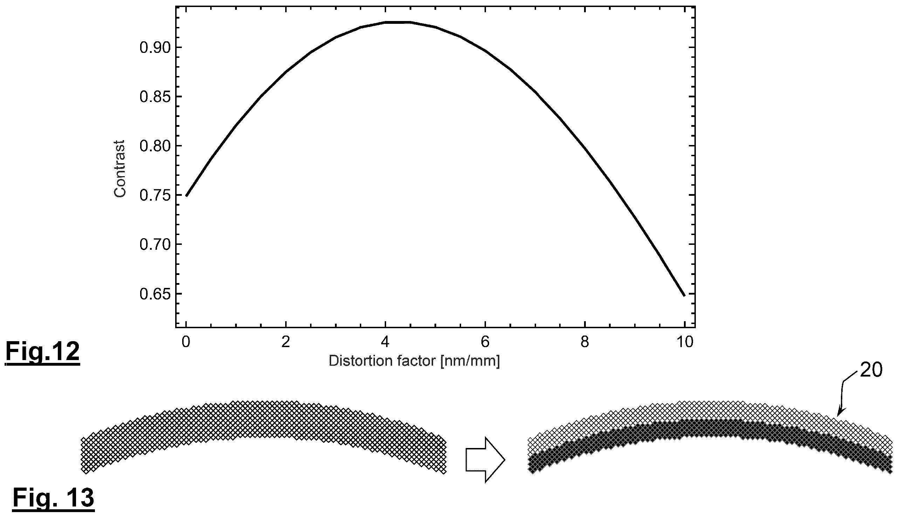

This can, as is shown in Figure 13, be achieved by a MEMS (*Micro-Electro-Mechanical Systems*) arrangement with a large number of individually actuable mirrors within the illumination device, wherein the different orientations of the mirrors (not shown to scale) in the right-hand part of Figure 13 are illustrated in different greyscales.

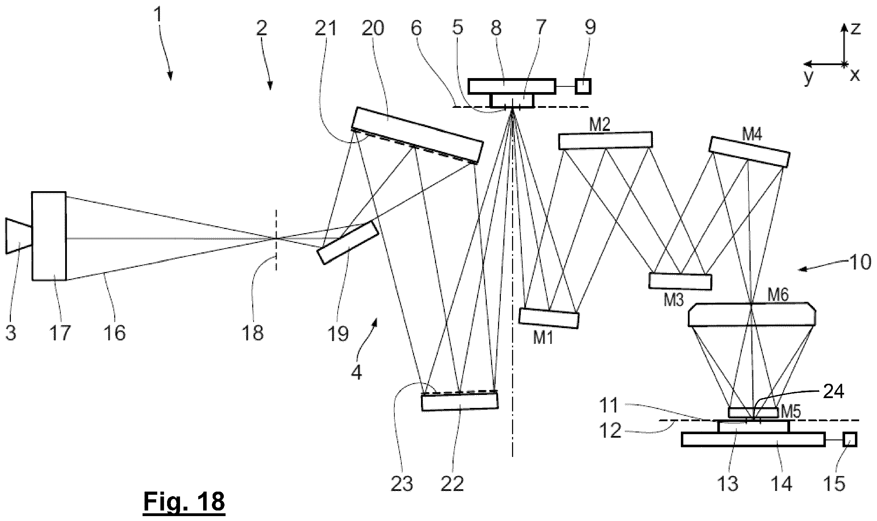

Such a MEMS facet mirror can be used as a field mirror 20 in the microlithographic projection exposure apparatus, which will be explained in more detail below with reference to Figure 18, within the illumination device.

The use of variably actuable mirrors within the context of the present invention has the additional advantage that the offset compensation can in combination with the components which will be explained further below be varied or optimized or optionally even deactivated, i.e. the arrangement according to the invention can be operated without major physical modifications "conventionally" and with offset compensation.

The inclination pattern of the mirror facets which is shown in Figure 13 is substantially static over the operation of the apparatus and produces a pole-dependent separated intensity distribution on the mask, described further below, preferably transversely to the scanning slit extent (i.e. in the y-direction).

In this way, the illumination is divided into two regions insofar as the upper part of the scanning slit is illuminated only - or at least mainly - with one illumination pole of a dipole setting, whereas the lower part of the scanning slit is illuminated only or mainly with the respective other illumination pole of the dipole setting; a peripheral overlap of the regions is possible in principle, however.

Alternatively, this effect could also be achieved without the use of MEMS by a "fixed" facet mirror which is divided into two parts with a respective adjustable inclination of the individual parts (not shown).

A further alternative possibility for implementing a field-dependent illumination distribution is described in WO 2016/034424 A1, which is intended to be incorporated here by reference, in that the partial field grouping elucidated therein, which is attainable by two MEMS mirror arrangements, is used by "jigsaw-type" controlling of the mirror facets in a targeted manner with respect to the pole-dependent intensity distribution which is desired here.

Implementation of the field-dependent image offset

Proceeding from the field-dependent illumination, a field-dependent image offset is produced in connection with the invention, which brings about at least partial compensation of the unwanted image offset.

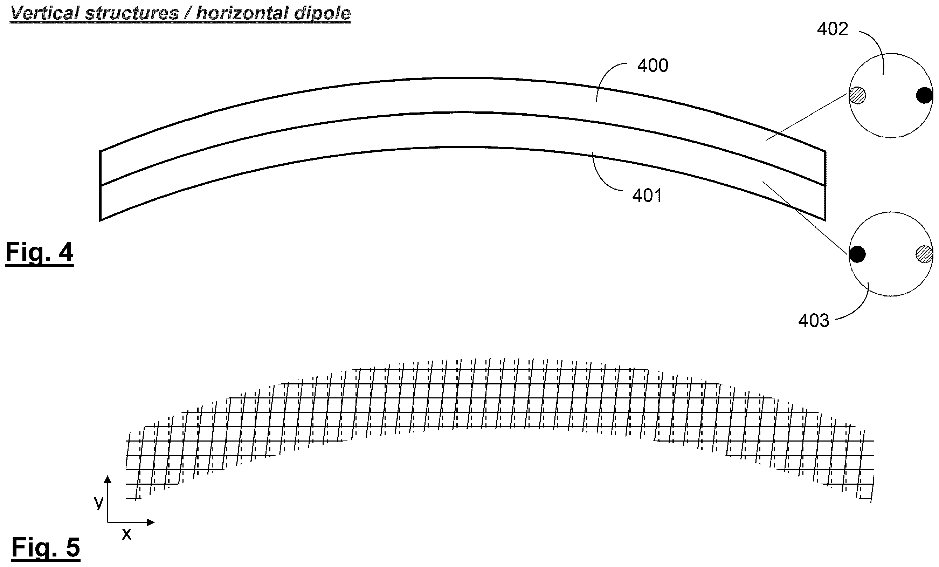

A particularly suitable measure in this regard is an oblique distortion of the mask or the reticle, which is explained with reference to Figures 4 to 11b, in combination with a corresponding adaptation of the feed speeds.

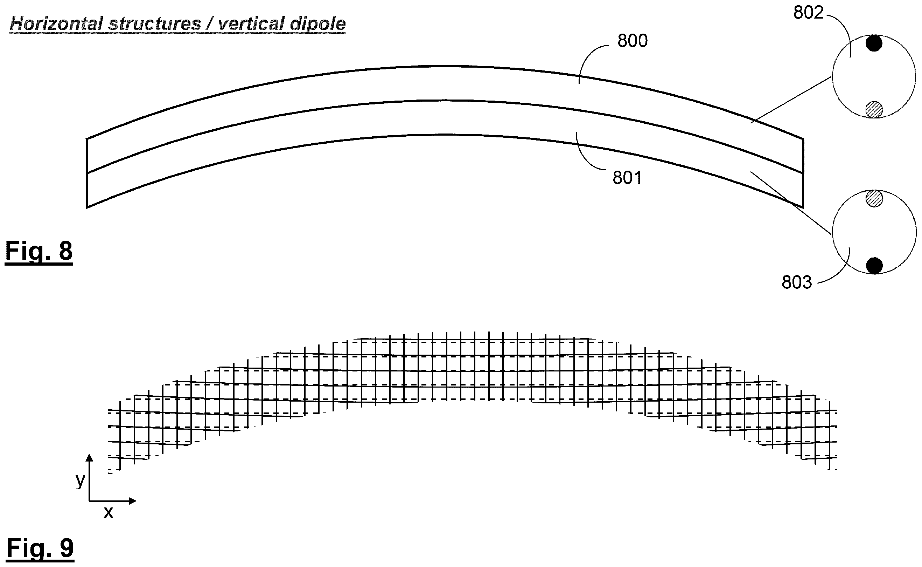

Here, a distinction is made between vertical mask structures with a substantially horizontal dipole orientation (indications given with general reference to the main direction of the scanning slit), see Figures 4 to 7b, and horizontal mask structures with a substantially vertical dipole orientation (see Figures 8 to 11b).

In the case of a substantially horizontal dipole (or an illumination source of a comparable geometry), as indicated in Figure 4, the offset compensation between the upper field 400 (illuminated by the right dipole, see 402) and the lower field 401 (illuminated by the left dipole, see 403) is achieved by the vertically obliquely distorted mask structure, illustrated in Figure 5, in combination with a compensatory x-movement of the wafer.

In principle, preferably a horizontally oriented dipole is used for imaging vertical structures (that is to say lines in a vertical orientation). The offset of these structures due to M3D effects extends in the horizontal orientation. Accordingly, the correction, that is to say the additional mask distortion and then also the movement of the stages, must also take place in the horizontal direction.

In Figure 5, the distorted structure (not to scale;

the distortion is shown enlarged approximately by the factor $10^5$) is shown in continuous lines and, for comparison purposes (as a reference point), the undistorted "straight" structure is indicated in dashed lines.

As can be seen, the distortion is zero in each case along a central line of the curved scanning slit and increases further upwards or downwards with the respective opposite sign, in particular according to the linear relationship, which was already mentioned further above and is valid in a first approximation

$$(x,y) \rightarrow (x + dfx^*(y - rfs(x)),y),$$

wherein

$rfs(x)$     describes a profile of the y-component of a specified distortion zero line of the scanning slit, depending on the x-position, and

$dfx$     represents a specified vertical distortion factor; typical values for $dfx$ range from approximately 1-10 nm/mm.

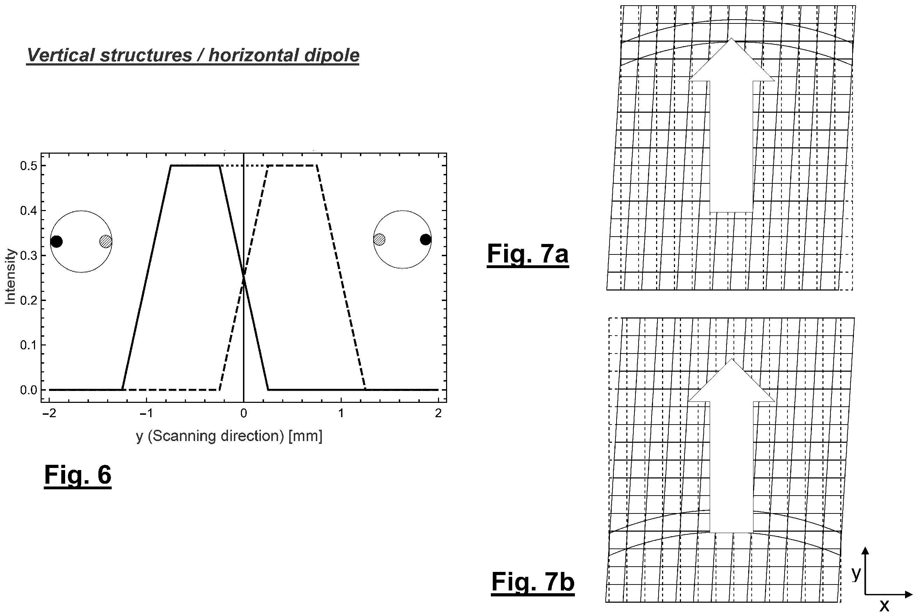

In this way it is then possible to achieve an intensity distribution as illustrated in Figure 6, wherein a substantially constant cumulative intensity (dotted line) can be achieved over the central region.

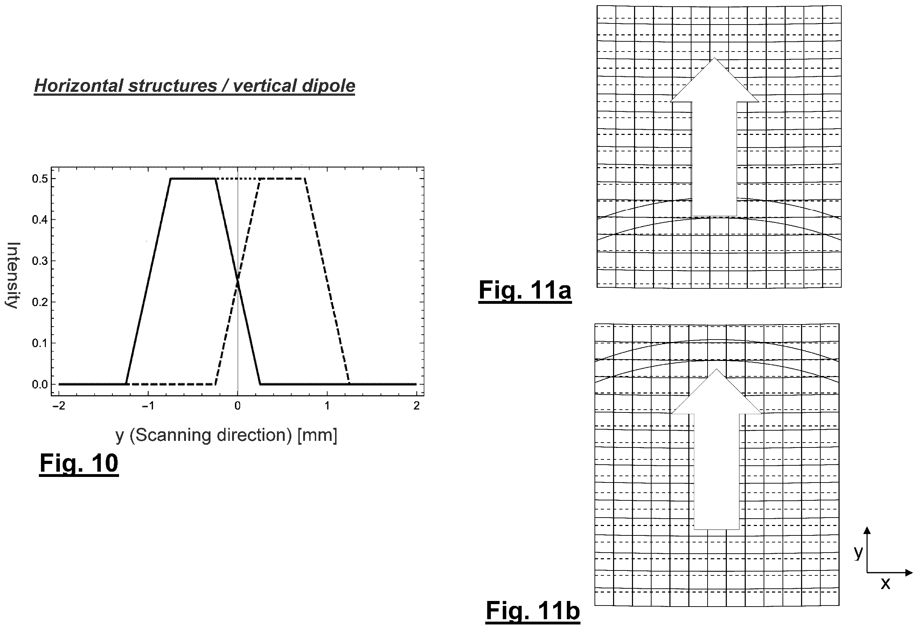

In the variant, illustrated in Figures 8 to 11b, with a substantially vertically oriented dipole for imaging horizontal structures, vertical mask distortion structures (that is to say those acting in the y-direction) are useful, as are illustrated in Figure 9 and Figures 11a and 11b.

Here, too, no distortion is provided along a central line, whereas in the y-direction in each case distortions with different signs are provided in the y-direction upwards and downwards, with the result that upper and lower regions 801, 802 illuminated by the respective poles (802, 803) produce a compensatory offset, with the result that according to Figure 10 an intensity distribution which is comparable to the case above (see Figure 6) is brought about.

The distortion can in this case be mathematically described in a first approximation as follows:
Distortion of the horizontal mask structures according to

$$(x,y) \rightarrow (x,y + dfy^*(y - rfs(x))),$$

wherein:

$rfs(x)$     is defined as above, and

$dfy$     represents a specified horizontal distortion factor (generally also described in an orientation-independent manner as sf).

For the compensation of the vertical mask distortion, the mask and the wafer stage must additionally be moved at slightly different feed speeds (for example with feed speeds that deviate from nominal feed speeds) according to the specified distortion factor.

Furthermore, it is possible in the case of a vertical distortion during a fine optimization for a specific adaptation of the intensity distributions between the upper field region 800 and the lower field region 801 to be necessary in order to compensate for the different angles of incidence between the upper and lower pole illumination.

Even if the implementation of the field-dependent image offset was described above with reference to mask distortions and corresponding adaptations in the mask feed/wafer feed, the present invention is expressly not limited to such an implementation. The compensatory offset also can be realized, for example, by additional optical elements in the beam path.

Optimization of the contrast ratio

The distortions of the mask described above themselves likewise cause imaging errors with a resultant deteriorated contrast ratio. As the distortion factor increases with the aim of full compensation of the image offset, the individual contrast ratios thus simultaneously decrease, which is why this is ultimately an optimization problem which according to the illustration in Figure 12 has a maximum in the exemplary embodiment at a distortion factor of approximately 4 nm/mm, which does not mean full offset compensation, see the intensity diagram in Figure 1 discussed in the introductory part, which is based on a corresponding offset of approximately sf = 4 nm/mm.

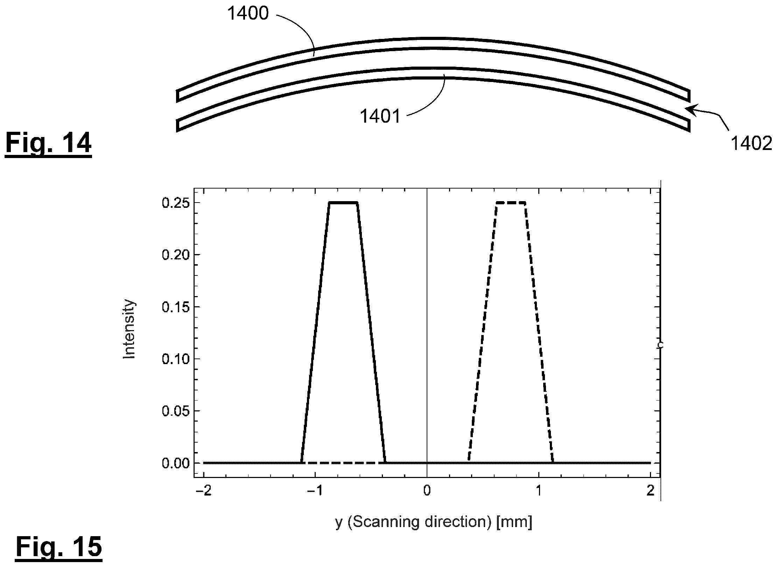

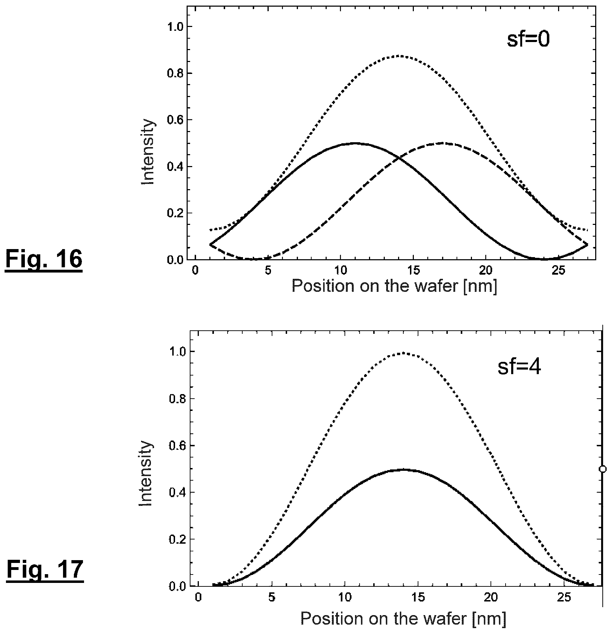

In order to achieve even further improvement of the contrast ratio, it is possible for the two illumination fields to be delineated from each other more severely, as indicated schematically in Figure 14 on the basis of narrow bands 1400, 1401, which are separated by a dark field 1402, as a result of which, according to Figures 15 to 17, an almost optimum contrast ratio of approximately 99% is obtained, see Figure 17 with a distortion factor sf = 4 nm/mm compared to Figure 16 without offset (sf=0).

However, such narrow illumination profiles result in a reduced effective etendue of the system, which can result in undesired losses for the light sources which are not coherent here.

Figure 18 schematically shows in the meridional section the possible setup of a microlithographic projection exposure apparatus designed for operation in the EUV range.

In accordance with Figure 18, the projection exposure apparatus 1 comprises an illumination device 2 and a projection lens 10. One embodiment of the illumination device 2 of the projection exposure apparatus 1 has, in addition to a light or radiation source 3, an illumination optical unit 4 for illuminating an object field 5 in an object plane 6. In an alternative embodiment, the light source 3 may also be provided as a module separate from the rest of the illumination device. In this case, the illumination device does not comprise the light source 3.

Here, a reticle 7 arranged in the object field 5 is exposed. The reticle 7 is held by a reticle holder 8. The reticle holder 8 is displaceable via a reticle displacement drive 9, in particular in a scanning direction. For explanation purposes, a Cartesian xyz-coordinate system is depicted in Figure 18. The x-direction runs perpendicularly to the plane of the drawing. The y-direction runs horizontally and the z-direction runs vertically. The scanning direction runs in the y-direction in Figure 18. The z-direction runs perpendicularly to the object plane 6. In embodiments of the invention, the reticle holder 8 is additionally also displaceable in the x-direction. Furthermore, in embodiments of the invention, a controller for changing the scanning speed is also provided.

The projection lens 10 serves for imaging the object field 5 into an image field 11 in an image plane 12. A structure on the reticle 7 is imaged onto a light-sensitive layer 24 of a wafer 13, which is arranged in the region of the image field 11 in the image plane 12. The wafer 13 is held by a wafer holder 14. The wafer holder 14 is displaceable by way of a wafer displacement drive 15, in particular in the y-direction. The displacement on the one hand of the reticle 7 via the reticle displacement drive 9 and on the other hand of the wafer 13 via the wafer displacement drive 15 can be carried out synchronously with each other.

The radiation source 3 is an EUV radiation source. The radiation source 3 in particular emits EUV radiation, which is also referred to below as used radiation or illumination radiation. In particular, the used radiation has a wavelength in the range between 5 nm and 30 nm. The radiation source 3 can be for example a plasma source, a synchrotron-based radiation source or a free electron laser (FEL). The illumination radiation 16 emanating from the radiation source 3 is focused by a collector 17 and propagates through an intermediate focus in an intermediate focal plane 18 into the illumination optical unit 4. The illumination optical unit 4 comprises a deflection mirror 19 and, arranged downstream thereof in the beam path, a first facet mirror 20 (having schematically indicated facets 21) and a second facet mirror 22 (having schematically indicated facets 23). The illumination optical unit 4 illustrated is merely an example, wherein, depending on the embodiment, for example the deflection mirror 19 can also be disposed at a different location or even not be present at all.

The first facet mirror 20 is also referred to as a field facet mirror, and the second facet mirror 2 is also referred to as a pupil facet mirror.

Within the context of the invention, provision may in particular be made for the field facet mirror 20 to be designed as a MEMS mirror with individually inclination-adjustable facets, with which a pole-dependent illumination distribution can then be set.

The projection lens 10 comprises a plurality of mirrors Mi (i= 1, 2, ...), which are numbered according to their arrangement in the beam path of the projection exposure apparatus 1. In the example illustrated in Figure 18, the projection lens 10 comprises six mirrors M1 to M6. Alternatives with four, five, seven, eight, ten, twelve or a different number of mirrors Mi are also possible. The penultimate mirror M5 and the last mirror M6 each have a through opening for the illumination radiation 16. The projection lens 10 is a doubly obscured optical unit. Singly obscured optical units (in which only one of the mirrors has a through opening for the illumination radiation) or optical units which are not obscured at all are likewise possible. The projection lens 10 has an image-side numerical aperture that is greater than 0.5 and may also be greater than 0.6, and may be for example up to 0.85.

With the possibilities for the offset compensation shown according to the invention, the mask stacks are subject to restrictions which are lower in this regard (with respect to the absorber materials and thickness) and can therefore be optimized further for example with respect to the imaging quality, for example contrast and reflectivity.

The horizontal and vertical offset structures can in principle also be combined.

It is also conceivable to compensate for higher-order aberrations, but this seems to be better achievable by wavefront modifications in the projection optical unit.

In addition, it is conceivable for the illumination to be divided into more than two regions in order to realize finer control over the M3D effects.

Even though the invention has also been described on the basis of specific embodiments, numerous variations and alternative embodiments will be apparent to a person skilled in the art, for example by the combination and/or exchange of features of individual embodiments. Accordingly, it goes without saying for a person skilled in the art that such variations and alternative embodiments are also encompassed by the present invention, and the scope of the invention is restricted only within the meaning of the appended patent claims and the equivalents thereof.

**Claims**

1. Method for operating a microlithographic projection exposure apparatus (1) having an illumination device (2) and a projection lens (10), wherein the illumination device (2) illuminates a mask (7) located in an object plane (6) of the projection lens (10), and the projection lens (10) images structures on this mask (7) onto a light-sensitive layer (24) located in an image plane (12) of the projection lens (10), wherein in a scanning operation the respective illuminated region of the mask is varied, **characterized in that**

   • the illumination of the mask (7) takes place as field-dependent illumination, in which different field regions of the object plane (6) are illuminated with differing illumination settings, and

   • during imaging of the object plane onto the image plane (12), a field-dependent image offset is produced, in which differing field regions of the object plane (6) are converted to differing image offsets.

2. Method according to Claim 1, **characterized in that** the interaction between the field-dependent illumination and the field-dependent image offset leads to an imaging contrast which results during the imaging onto the image plane (12) being increased compared to imaging without a field-dependent image offset.

3. Method according to Claim 1 or 2, **characterized in that** the mask (7) is illuminated via an elongate scanning slit, in particular in the shape of a circle segment, wherein the scanning direction runs transversely to the scanning slit and wherein a plurality of field regions of the object plane (6) are illuminated during the scanning operation in each case with differing illumination settings.

4. Method according to Claim 3, **characterized in that** at least two field regions of the object plane (6) overlap one another.

5. Method according to Claim 3 or 4, **characterized in that** the field-dependent image offset is produced during the imaging onto the image plane (12) in dependence on the transverse directional position of the radiation that is incident on the scanning slit.

6. Method according to any of Claims 3 to 5, **characterized in that** the field-dependent illumination of the mask (7) takes place via a facet mirror arrangement or a mirror array arrangement having micro-electromechanical systems (MEMS), wherein the radiation from a first illumination pole (301) leads to lighting mainly in a lower region of the scanning slit and the radiation from a second illumination pole (302) leads to lighting mainly in an upper region of the scanning slit.

7. Method according to Claim 6, **characterized in that** a separating dark field (1402) is provided between the lighting in the upper region of the scanning slit and the lighting in the lower region of the scanning slit.

8. Method according to any of the preceding claims, **characterized in that** the field-dependent image offset is realized by the horizontally extending mask structures of the mask (7) and/or vertically extending mask structures of the mask (7) each having a specified distortion profile, wherein a mask feed taking place during the scanning operation and/or a feed of the light-sensitive layer (24) is modified in relation to a nominal mask feed for compensating the distortion profile.

9. Method according to Claim 8, **characterized in that**

   - during the illumination of the mask (7) with horizontally spaced-apart illumination poles, mask structures of the mask (7) are distorted in the horizontal direction, wherein this horizontal distortion is compensated for by an additional movement offset of the mask (7) and the light-sensitive layer (24) in the horizontal direction; and/or **in that**
   - during the illumination of the mask (7) with vertically spaced-apart illumination poles, mask structures of the mask (7) are distorted in the vertical direction, wherein this vertical distortion is compensated for by a feed speed between the mask (7) and the light-sensitive layer (24) which deviates from a nominal feed speed.

10. Method according to Claim 9, **characterized in that** the distortion of the mask structures in a ring-segment-shaped scanning slit, which extends in the horizontal direction and in which the field-dependent illumination distribution varies in the transverse direction, is implemented at least approximately according to one or more of the following transformation formulas:

    - distortion of the vertical mask structures according to

    $$(x,y) \rightarrow (x + dfx^*(y - rfs(x)),y),$$

    and/or
    - distortion of the horizontal mask structures according to

    $$(x,y) \rightarrow (x,y + dfy^*(y - rfs(x))),$$

    where:

    rfs(x) describes a profile of the y-component of a specified distortion zero line of the scanning slit, depending on the x-position, and
    dfx,dfy represents a specified vertical or horizontal distortion factor, wherein both factors may also be identical.

11. Method according to any of Claims 1 to 5, **characterized in that** the field-dependent image offset is implemented by a manipulation carried out during the scanning operation within the projection lens (10).

12. Microlithographic mask (7), **characterized in that** it is designed to be used in a method according to any of Claims 1 to 11.

13. Microlithographic projection exposure apparatus (1), which is designed for carrying out a method according to any of Claims 1 to 11.

**Fig. 1**

**Fig. 2**
(Prior art)

**Fig. 3**

Vertical structures / horizontal dipole

**Fig. 4**

**Fig. 5**

**Fig. 7a**

**Fig. 7b**

*Vertical structures / horizontal dipole*

**Fig. 6**

EP 4 542 302 A1

*Horizontal structures / vertical dipole*

**Fig. 8**

800

801

802

803

y

x

**Fig. 9**

**Fig. 11a**

**Fig. 11b**

*Horizontal structures / vertical dipole*

Intensity

y (Scanning direction) [mm]

**Fig. 10**

**Fig.12**

**Fig. 13**

**Fig. 14**

EP 4 542 302 A1

**Fig. 15**

Fig. 16

Fig. 17

**Fig. 18**

EP 4 542 302 A1

**Europäisches Patentamt**
**European Patent Office**
**Office européen des brevets**

# EUROPEAN SEARCH REPORT

**Application Number**

EP 24 19 8801

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/217506 A1 (DEGUENTHER MARKUS [DE] ET AL) 2 August 2018 (2018-08-02) | 1-4,6,7, 12,13 | INV. G03F7/00 |
| Y | * paragraph [0004] - paragraph [0160] * | 5,11 | |
| A | * figures 1-3,7 * | 8-10 | |
| | ----- | | |
| Y | US 2012/320358 A1 (RUOFF JOHANNES [DE]) 20 December 2012 (2012-12-20) | 5,11 | |
| A | * paragraph [0034] - paragraph [0086] * * figure 3 * | 1,12,13 | |
| | ----- | | |

**TECHNICAL FIELDS SEARCHED (IPC)**

G03F

The present search report has been drawn up for all claims

| Place of search | Date of completion of the search | Examiner |
|---|---|---|
| Munich | 5 March 2025 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 8801

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2025

| Patent document cited in search report | Publication date | Patent family member(s) | Publication date |
|---|---|---|---|
| US 2018217506 A1 | 02-08-2018 | JP 6643466 B2 | 12-02-2020 |
| | | JP 2018531412 A | 25-10-2018 |
| | | US 2018217506 A1 | 02-08-2018 |
| | | WO 2017050360 A1 | 30-03-2017 |
| US 2012320358 A1 | 20-12-2012 | CN 102834776 A | 19-12-2012 |
| | | DE 102010029651 A1 | 08-12-2011 |
| | | JP 5768124 B2 | 26-08-2015 |
| | | JP 6527397 B2 | 05-06-2019 |
| | | JP 2013524497 A | 17-06-2013 |
| | | JP 2015222428 A | 10-12-2015 |
| | | JP 2019095814 A | 20-06-2019 |
| | | KR 20130019384 A | 26-02-2013 |
| | | TW 201202866 A | 16-01-2012 |
| | | US 2012320358 A1 | 20-12-2012 |
| | | US 2015234289 A1 | 20-08-2015 |
| | | WO 2011120821 A1 | 06-10-2011 |

EPO FORM P0459

For more details about this annex : see Official Journal of the European Patent Office, No. 12/82

## REFERENCES CITED IN THE DESCRIPTION

**Patent documents cited in the description**

- DE 102023127297
- WO 2020221556 A1
- DE 102014217611 A1
- WO 2016034424 A1

**Non-patent literature cited in the description**

- **L. WISCHMEIER et al.** High-NA EUV lithography optics becomes reality. *Proc. SPIE 11323, Extreme Ultraviolet (EUV) Lithography XI*, 23 March 2020, 1132308